# EUROPEAN PATENT SPECIFICATION

(11) **EP 2 541 600 B1**
(45) Date of publication and mention of the grant of the patent: **14.02.2018**
(21) Application number: 12160906.9
(22) Date of filing: 23.03.2012
(51) Int. Cl.: H01L 27/115, H01L 29/423, H01L 29/792, G11C 16/00

(54) **Non-volatile semiconductor memory cell with dual functions and method of operating thereof**
Nichtflüchtige Halbleiterspeicherzelle mit Doppelfunktionen und Verfahren zum Betreiben
Cellule de mémoire non volatile à semi-conducteur à fonctions doubles et sa méthode d'utilisation

(30) Priority: 29.06.2011 US 201161502336 P
(43) Date of publication of application: 02.01.2013
(73) Proprietor: eMemory Technology Inc., Hsin-Chu 30075 (TW)
(72) Inventor: Lu, Hau-Yan, 300 Hsinchu City (TW); Chen, Hsin-Ming, 300 Hsinchu City (TW); Yang, Ching-Sung, 300 Hsinchu City (TW)
(74) Representative: Becker Kurig Straus

(56) References cited:
- US-A1- 2006 028 868
- US-A1- 2006 076 607
- US-A1- 2009 134 449
- US-A1- 2011 024 823

## Description

### Field of the Invention

The present invention relates to a non-volatile semiconductor memory cell with dual functions according to the pre-characterizing clause of claim 1.

### Background of the Invention

Non-volatile memory is a type of memory that retains information even when power is not supplied to memory blocks thereof. Some examples include magnetic devices, optical discs, flash memory, and other semiconductor-based memory technologies. Non-volatile memory can be classified by reprogramming capability. For example, some non-volatile memory can only be programmed once (one time programmable read only memory, OTP ROM), and other types may be programmed and reprogrammed multiple times. Considering the fabrication and process, the nonvolatile memory technology can be classified into stand-alone and embedded memory types. With advancements in semiconductor memory technologies, embedded non-volatile memory has an advantage of being able to embed substantial amounts of memory cells into integrated circuits (ICs). In other words, the embedded memory cells are formed in the same process with the ICs. A key feature of the embedded non-volatile memory is its lack of complex and expensive fabrication steps. These non-volatile memory technologies are also classified as Complementary Metal-Oxide-Semiconductor (CMOS) non-volatile memory or logic-based non-volatile memory.

One goal of non-volatile memory devices is to fit increasing numbers of memory cells into smaller chip areas while utilizing the same fabrication process as other CMOS devices in the IC. One method for increasing the number of memory cells utilizes charge storage structures to form 2-bit non-volatile semiconductor memory transistors.

Many various topologies are provided in the prior art for forming memory cells with charge storage layers. For example, U.S. Patent Application 2009/0134449 A1 discloses a highly integrated nonvolatile semiconductor memory device having a plurality of memory cells formed in a plurality of active regions sectioned by a plurality of isolations extending in the Y direction and deeper than a well. U.S. Patent Application 2006/0076607 A1 also discloses a semiconductor device having an insulated floating gate disposed on a semiconductor substrate, an insulated program gate formed on a side surface of the floating gate, and an insulated erase gate disposed adjacent the floating gate. US2011/0024823 discloses a non-volatile semiconductor memory device with intrinsic charge trapping layer. U.S. Patent Application 2006/0028868 A1 also discloses another memory cell device. However, the memory cells are slow and inefficient.

### Summary of the Invention

This in mind, the present invention aims at providing a non-volatile semiconductor memory cell with dual functions that can have simpler structure to realize a one-time programming function and a multi-time programming function easily.

This is achieved by a non-volatile semiconductor memory cell with dual functions according to claim 1. The dependent claims pertain to corresponding further developments and improvements.

As will be seen more clearly from the detailed description following below, the claimed non-volatile semiconductor memory cell with dual functions includes a substrate of a first conductivity type comprising an active region, a first gate, a second gate, a third gate, a charge storage layer filled between the second gate and the third gate, a first diffusion region, a second diffusion region, and a third diffusion region and an oxide layer below the second gate and the third gate ruptured with the first voltage wherein the select-gate voltage is half the first voltage, and the third voltage is equal to grounded voltage in program mode of the one-time programming function. The first gate is formed fully on the active region for receiving a select-gate voltage. The second gate is formed partially on the active region on a first side of the first gate for receiving a first voltage corresponding to a one-time programming function of the dual function and a second voltage corresponding to a multi-time programming function of the dual function, where the first gate and the second gate are separated by a first distance. The third gate is formed partially on the active region on the first side of the first gate for receiving the first voltage corresponding to the one-time programming function and the second voltage corresponding to the multi-time programming function, where the first gate and the third gate are separated by the first distance, and the second gate and the third gate are separated by a second distance. The charge storage layer is formed on the substrate, and fills between the second gate and the third gate. The first diffusion region is a second conductivity type opposite the first conductivity type formed on the surface of the active region on a second side of the first gate opposite the first side of the first gate for receiving a third voltage corresponding to the one-time programming function and a fourth voltage corresponding to the multi-time programming function. The second diffusion region is the second conductivity type formed on the surface of the active region on a first side of the second gate opposite the first side of the first gate for receiving a fifth voltage corresponding to the multi-time programming function. The third diffusion region is the second conductivity type formed on the surface of the active region between the first gate and the second/third gate.

### Brief Description of the Drawings

In the following, the invention is further illustrated by way of example, taking reference to the accompanying drawing. Thereof:
FIG. 1 is a diagram of a semiconductor memory transistor,
FIG. 2 is a diagram of a CMOS non-volatile memory cell,
FIG. 3 is a diagram of a complementary metal-oxide-semiconductor non-volatile memory cell according to one embodiment of the present invention,
FIG. 4 is a diagram illustrating memory cell with dual functions according to one embodiment of the present invention,
FIG. 5 is a cross-sectional diagram of the memory cell with the dual functions,
FIG. 6 shows the memory cell in program mode of the one-time programming function,
FIG. 7 shows the memory cell in read mode of the one-time programming function,
FIG. 8 shows a memory array in the program mode of the one-time programming function,
FIG. 9 shows the memory array in the read mode of the one-time programming function,
FIG. 10 is a cross-sectional diagram of the CMOS non-volatile memory cell in program mode,
FIG. 11 is a diagram of the CMOS non-volatile memory cell of FIG. 10 in erase mode, and
FIG. 12 is a diagram of an array of complementary metal-oxide-semiconductor non-volatile memory cells according to another embodiment of the present invention.

### Detailed Description

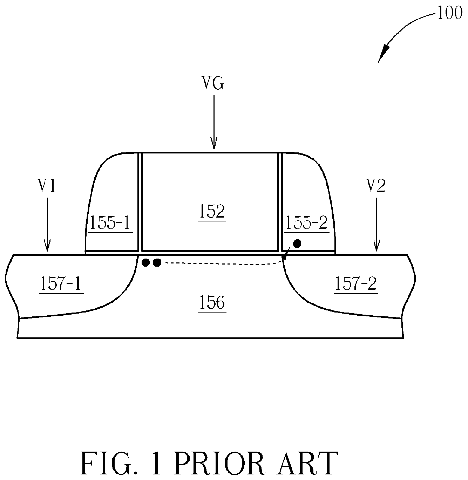

Please refer to FIG. 1, which is a diagram of a semiconductor memory transistor 100. The semiconductor memory transistor 100 is formed on a substrate, which has two implanted source/drain regions 157-1 and 157-2 and a channel region 156. The channel region 156 and the implanted source/drain regions 157-1, 157-2 are formed under a gate region 152, and two charge storage structures 155-1 and 155-2 are formed on either side of the gate region 152. The charge storage structures 155-1, 155-2 are made of a spacer material that has charge trapping properties, e.g. silicon-nitride or a high-k dielectric. The charge storage structure 155-2 is programmed by applying a gate voltage VG of 5 Volts and a drain voltage V2 of 5 Volts, with a source voltage V1 of 0 Volts. Thus, channel hot electrons from the source region 157-1 may enter the charge storage region 155-2 by traveling through the channel region 156. To erase the charge storage structure 155-2, a gate voltage VG of -5 Volts and a drain voltage V2 of -5 Volts may be applied, inducing band-to-band tunneling holes to enter the charge storage structure 155-2.

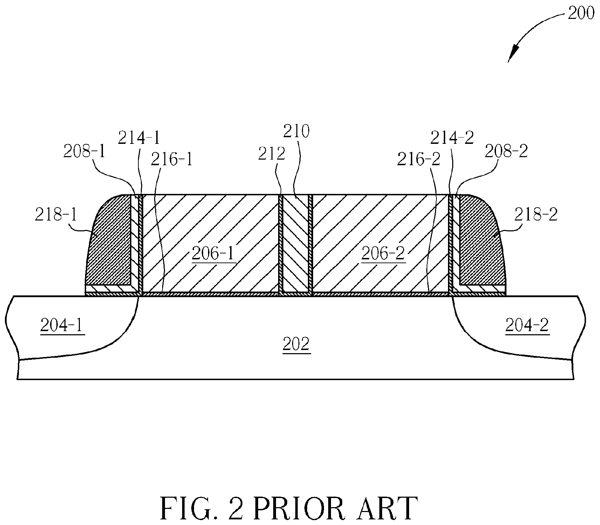

Another technique for providing a Complementary Metal-Oxide-Semiconductor (CMOS) non-volatile memory cell that is fabricated using standard CMOS processes is shown in FIG. 2, which is a diagram of a CMOS non-volatile memory cell 200 ("memory cell 200" hereinafter) according to the prior art. The memory cell 200 is fabricated on a substrate 202, and has two source/drain regions 204-1 and 204-2, and two poly gates 206-1 and 206-2 separated from the substrate 202 by gate dielectric layers 208-1 and 208-2, respectively. The gate dielectric layers 208-1/208-2 are formed of oxide-nitride-oxide (ONO) material. A programming layer 210 is formed between the two poly gates 206-1, 206-2, and is isolated from the two poly gates 206-1, 206-2 by an isolating layer 212. The programming layer 210 provides charge storage similar to a silicon-oxide-nitride-oxide-silicon (SONOS) structure utilized in flash memory cells. However, in the CMOS non-volatile memory cell 200, the two poly gates 206-1, 206-2 are utilized to program the programming layer 210. Silicon-nitride sidewall spacers 214-1 and 214-2 are deposited with the programming layer 210 for controlling e-field fringing near the source/drain regions 204-1, 204-2. Sidewall isolating layers 216-1 and 216-2 are grown with the isolating layer 212, and isolate the SiN sidewall spacers 214-1, 214-2 from the poly gates 206-1, 206-2 and the substrate 202. Second sidewall spacers 218-1, 218-2 are formed from silicon oxide. The programming layer 210 is programmed by grounding the poly gate 206-1, and leaving the source/drain regions 204-1, 204-2 and substrate 202 floating. A high voltage is applied to the poly gate 206-2 to attract electrons from the poly gate 206-1 into the programming layer 210 through the isolating layer 212. The negative charge of the programming layer 210 over the channel causes a negative bias, increasing threshold voltage of the memory cell 200 relative to non-programmed transistors in the same circuit.

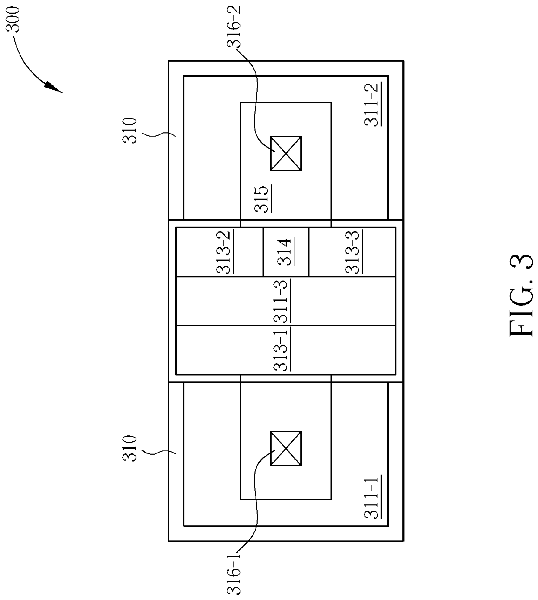

Please refer to FIG. 3, which is a diagram of a complementary metal-oxide-semiconductor non-volatile memory cell 300 (hereinafter "the memory cell 300") according to an embodiment of the present invention. The memory cell 300 may be formed over an active region 315 in a P-well region 310 of a substrate. Although CMOS P-well topology is described, the embodiments described herein are also suitable for application to CMOS N-well topology. A first N+ diffusion region 311-1 may be formed on a surface of the active region 315 on a left (second) side of a first polysilicon gate 313-1, a second N+ diffusion region 311-2 may be formed on the surface of the active region 315 on a first side of a second polysilicon gate 313-2 opposite a right (first) side of the first polysilicon gate 313-1, and a third N+ diffusion region 311-3 may be formed on the surface of the active region 315 between the first polysilicon gate 313-1 and the second polysilicon gate 313-2.

The second polysilicon gate 313-2 and the third polysilicon gate 313-3 may be formed a second distance apart from each other. Further, the second polysilicon gate 313-2 and the third polysilicon gate 313-3 may both be formed a first distance apart from the first polysilicon gate 313-1. The second distance and the first distance may be measured along perpendicular axes. The second distance may be of a size suitable for forming a charge storage (self-aligning nitride, SAN) layer 314 in a space between the second and third polysilicon gates 313-2, 313-3, and the second distance may be of a size suitable for not forming an SAN layer between the first polysilicon gate 313-1 and the second and third polysilicon gates 313-2, 313-3. For example, in a 90nm/65nm node, a range of 20nm to 200nm of separation between the second and third polysilicon gates 313-2, 313-3 may allow formation of the charge storage layer 314, e.g. the SAN layer, in the space between the second and third polysilicon gates 313-2, 313-3. Contacts 316-1 and 316-2 may be formed in the active region 315 over the diffusion regions 311-1 and 311-2, respectively, for charging the diffusion regions 311-1, 311-2 with voltage signals applied to the contacts 316-1, 316-2.

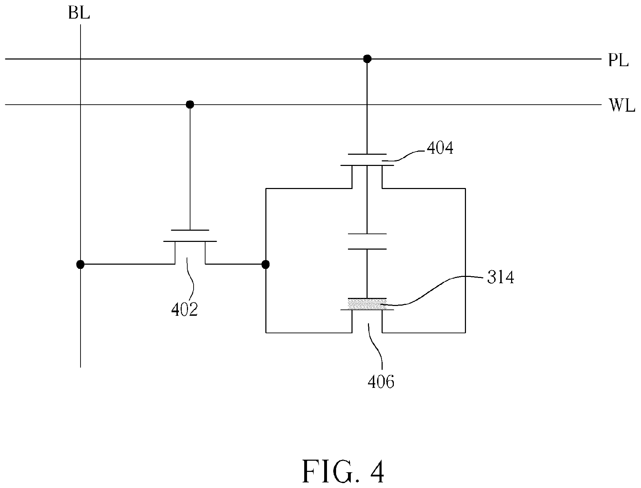

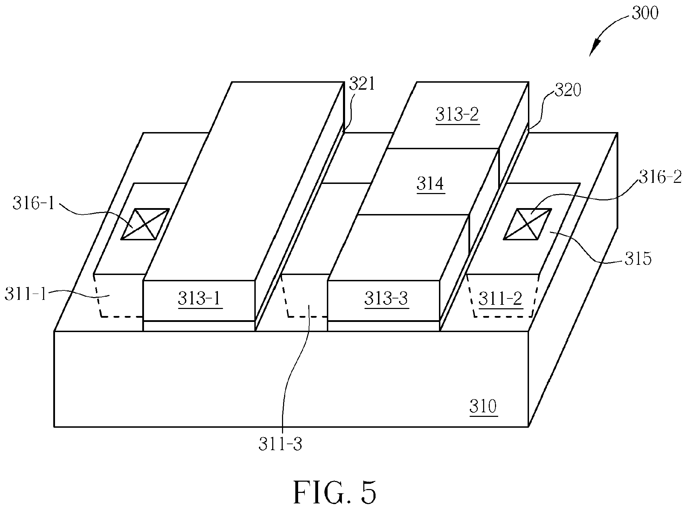

Please refer to FIG. 4 and FIG. 5. FIG. 4 is a diagram illustrating the memory cell 300 with dual functions according to one embodiment of the present invention, and FIG. 5 is a cross-sectional diagram of the memory cell 300 with the dual functions. As shown in FIG. 4, a bit line BL is coupled to the contact 316-1, a word line WL is coupled to the first polysilicon gate 313-1, and a program line PL is coupled to the second and the third polysilicon gates 313-2 and 313-3. As shown in FIG. 5 and FIG. 4, the first polysilicon gate 313-1, the first N+ diffusion region 311-1, and the third N+ diffusion region 311-3 can function as a switch 402, the second polysilicon gate 313-2, the third polysilicon gate 313-3, the second N+ diffusion region 311-2, and the third N+ diffusion region 311-3 can function as a one-time programming function cell 404 (that is, the second polysilicon gate 313-2 and the third polysilicon gate 313-3 function as anti-fuses), and the second polysilicon gate 313-2, the third polysilicon gate 313-3, the charge storage layer 314, the second N+ diffusion region 311-2 , and the third N+ diffusion region 311-3 can function as a multi-time programming function cell 406.

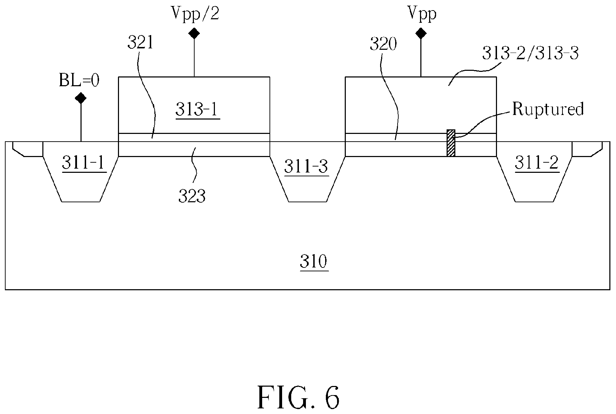

Please refer to FIG. 6. FIG. 6 shows the memory cell 300 in program mode of the one-time programming function. In the program mode of the one-time programming function, a high voltage Vpp is applied to the second and the third polysilicon gates 313-2, 313-3, and the first N+ diffusion region 311-1 is coupled to ground (that is, the bit line BL coupled to the contact 316-1 has 0 Volts), so the high voltage Vpp can rupture a gate oxide layer 320 formed below the second and third polysilicon gates 313-2, 313-3 according to a voltage drop between the second and third polysilicon gates 313-2, 313-3 and the first N+ diffusion region 311-1. Half the high voltage Vpp is applied to the first polysilicon gate 313-1 to maintain turning-on of a channel region 323 between the first N+ diffusion region 311-1 and the third N+ diffusion region 311-3, and the half of the high voltage Vpp cannot rupture a gate oxide layer 321 formed below the first polysilicon gate 313-1. However, the half of the high voltage Vpp applied to the first polysilicon gate 313-1 can transfer the ground voltage from the first N+ diffusion region 311-1 to the third N+ diffusion region 311-3.

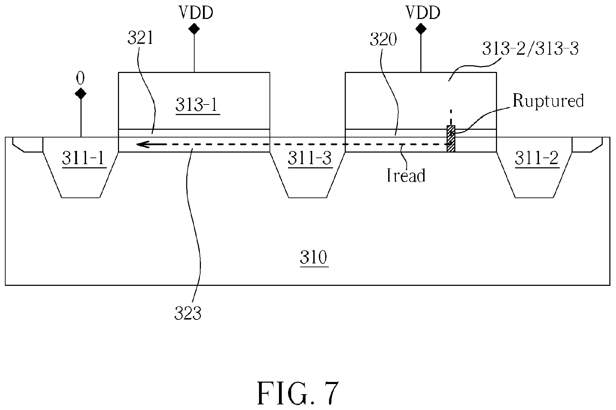

Please refer to FIG. 7. FIG. 7 shows the memory cell 300 in read mode of the one-time programming function. In the read mode of the one-time programming function, a high voltage VDD is applied to the second and the third polysilicon gates 313-2, 313-3, and the first N+ diffusion region 311-1 is coupled to ground (that is, the bit line BL coupled to the contact 316-1 has 0 Volts), and the high voltage VDD is also applied to the first polysilicon gate 313-1 to maintain turning-on of the channel region 323. In this way, an electrical current Iread may flow from the second and the third polysilicon gates 313-2, 313-3 toward the first N+ diffusion region 311-1. Therefore, the bit line BL can sense current Iread (that is, logic "1"). But, the present invention is not limited to the logic "1" corresponding to the bit line BL sensing current Iread. Thus, in the one-time programming function of the memory cell 300, when the second and the third polysilicon gates 313-2, 313-3 are not ruptured, the memory cell 300 stores logic "0"; when the second and the third polysilicon gates 313-2, 313-3 are ruptured, the memory cell 300 stores the logic "1".

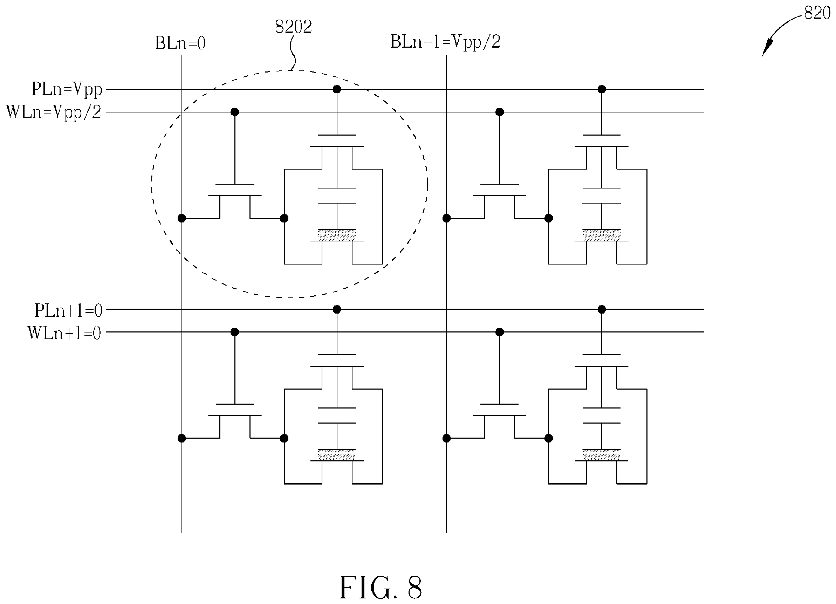

Please refer to FIG. 8. FIG. 8 shows a memory array 820 in the program mode of the one-time programming function. As shown in FIG. 8, a memory cell 8202 of the memory array 820 is programmed, and other memory cells of the memory array 820 are not programmed. A bit line BLn, a word line WLn, and a program line PLn are coupled to the memory cell 8202. Therefore, the high voltage Vpp is applied to the program line PLn, the bit line BLn is grounded, and half the high voltage Vpp is applied to the word line WLn. Half the high voltage Vpp is applied to bit lines (such as a bit line BLn+1) coupled to other memory cells, and word lines (such as a word line WLn+1) and program lines (such as a program line PLn+1) coupled to other memory cells are grounded. Thus, the memory cell 8202 is programmed (the logic "1"), and other memory cells of the memory array 820 are not programmed (the logic "0").

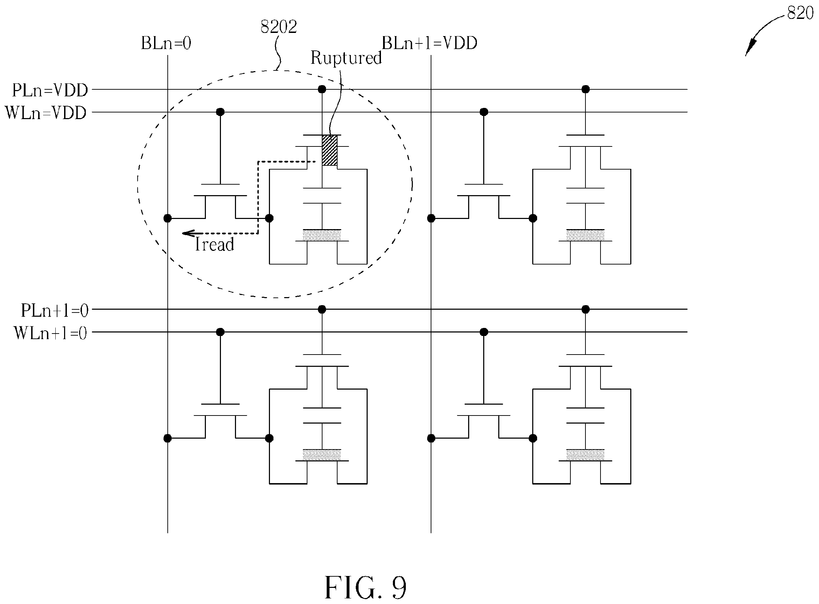

Please refer to FIG. 9. FIG. 9 shows the memory array 820 in the read mode of the one-time programming function. As shown in FIG. 9, the memory cell 8202 of the memory array 820 stores the logic "1", and other memory cells of the memory array 820 store the logic "0" or the logic "1". In the read mode of the one-time programming function, the high voltage VDD is applied to the program line PLn and the word line WLn, and the bit line BLn is grounded. The high voltage VDD is applied to the bit line BLn+1 to inhibit leakage current in adjacent programmed memory cells coupled to the word line WLn, and the word line WLn+1 and the program line PLn+1 are grounded. Thus, the bit line BLn can sense current Iread (the logic "1" stored in the memory cell 8202).

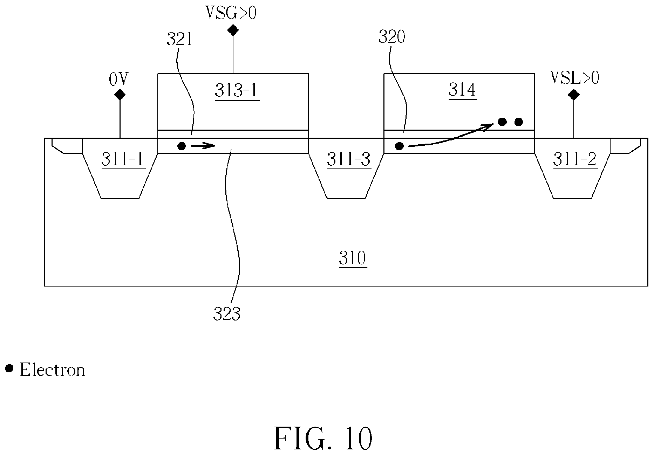

Please refer to FIG. 10, which is a cross-sectional diagram of the CMOS non-volatile memory cell 300 of FIG. 3. FIG. 10 shows the memory cell 300 in program mode of the multi-time programming function. The gate oxide layer 321 may be formed between the first polysilicon gate 313-1 and the P-well region 310. In program mode, for an N-type Metal-Oxide-Semiconductor Field-Effect Transistor (MOSFET), a high voltage VAG (>0) may be applied to the second polysilicon gate 313-2 and the third polysilicon gate 313-3, a gate voltage VSG larger than the threshold voltage V_{TH} of the memory cell 300 may be applied to the first polysilicon gate 313-1, a high voltage VSL (>0) may be applied to the second N+ diffusion region 311-2, and the first N+ diffusion region 311-1 may be grounded. In this way, channel hot electrons may travel from the first N+ diffusion region 311-1 through the channel region 323 formed between the first N+ diffusion region 311-1 and the third N+ diffusion region 311-3. The channel hot electrons can arrive at the third N+ diffusion region 311-3, and can be injected into the charge storage layer 314 and trapped in the charge storage layer 314. Further, peak channel hot electron injection may be shifted to the area under the charge storage layer 314 next to the second N+ diffusion region 311-2, and current density may be enhanced by applying voltage to the second and third polysilicon gates 313-2, 313-3.

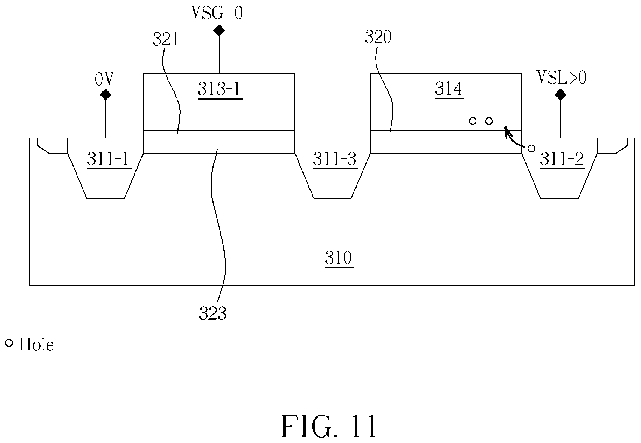

Please refer to FIG. 11, which is a diagram of the CMOS non-volatile memory cell 300 of FIG. 10 in erase mode of the multi-time programming function. Band-to-band tunneling hot hole (BBHH) injection may be utilized to erase the memory cell 300. As shown in FIG. 11, a low voltage VSG (e.g., equal to 0V) may be applied to the first polysilicon gate 313-1, and a low voltage VAG (<OV) may be applied to the second and third polysilicon gates 313-2, 313-3. The first N+ diffusion region 311-1 is floating. A high voltage VSL (>OV) may be applied to the second N+ diffusion region 311-2. In this way, BBHH injection may occur, such that hot holes may travel from the second N+ diffusion region 311-2 to the charge storage layer 314. Therefore, the memory cell 300 can be erased.

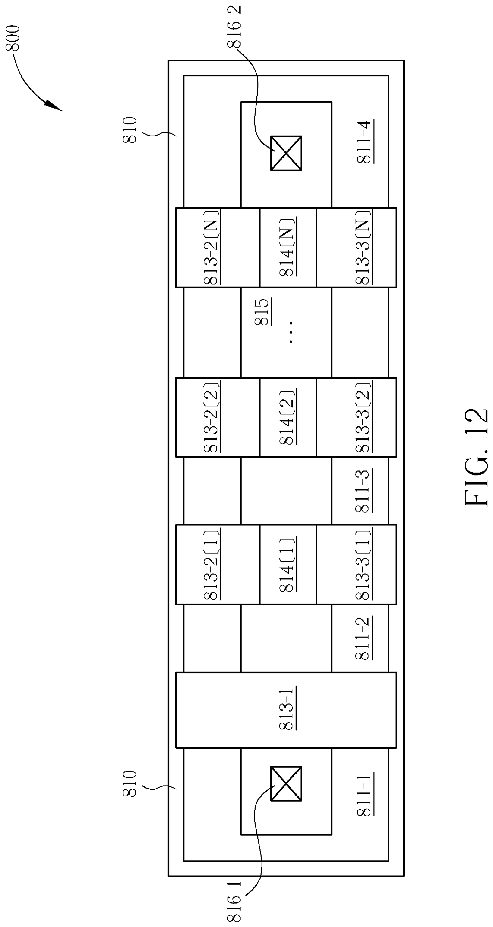

Please refer to FIG. 12, which is a diagram of an array 800 of complementary metal-oxide-semiconductor non-volatile memory cells according to another embodiment of the present invention. The array of memory cells 800 may be considered a logical NAND type array comprising a plurality of memory cells in a memory string. Each memory string may comprise a plurality of memory cells as shown in FIG. 12. The memory cells 800 may be formed over an active region 815 in a P-well region 810 of a substrate. As shown in FIG. 12, a total number N memory cells may be formed. A first N+ diffusion region 811-1 may be formed under a first polysilicon gate 813-1. A second N+ diffusion region 811-2 may be formed under the first polysilicon gate 813-1 and second and third polysilicon gates 813-2[1], 813-3[1]. A third N+ diffusion region 811-3 may be formed under the second and third polysilicon gates 813-2[1], 813-3[1] and under fourth and fifth polysilicon gates 813-2[2], 813-3[2]. A fourth N+ diffusion region 811-4 may be formed under sixth and seventh polysilicon gates 813-2[N], 813-3[N]. To form a continuous channel between the first N+ diffusion region 811-1 and the fourth N+ diffusion region 811-4, each charge storage layer 814[1], 814[2],...,814[N] may store charges, e.g. electrons. If one or more of the charge storage layers 814[1], 814[2],...,814[N] does not store charges, current may not pass from the first N+ diffusion region 811-1 to the fourth N+ diffusion region 811-4. Thus, NAND-type operation may be achieved through use of the architecture shown in FIG. 12.

The second polysilicon gate 813-2[1] and the third polysilicon gate 813-3[1] may be formed a first distance apart from each other. Further, the second polysilicon gate 813-2[1] and the third polysilicon gate 813-3[1] may both be formed a second distance apart from the first polysilicon gate 813-1. The fourth polysilicon gate 813-2[2] and the fifth polysilicon gate 813-3[2] may be formed the first distance apart from each other. The fourth polysilicon gate 813-2[2] may be formed a third distance apart from the second polysilicon gate 813-2[1]. The fifth polysilicon gate 813-3[2] may be formed the third distance apart from the third polysilicon gate 813-3[1]. The third distance may be the same as the second distance. The first distance may be of a size suitable for forming the self-aligning nitride (SAN) layers 814[1], 814[2],...,814[N] in spaces between the second and third polysilicon gates 813-2[1], 813-3[1], fourth and fifth polysilicon gates 813-2[2], 813-3[2], through the sixth and seventh polysilicon gates 813-2[N], 813-3[N]. The second distance may be of a size suitable for not forming an SAN layer between the first polysilicon gate 813-1 and the second and third polysilicon gates 813-2[1], 813-3[1]. The third distance may be of a size suitable for not forming an SAN layer between the second and third polysilicon gates 813-1[1], 813-3[1] and the fourth and fifth polysilicon gates 813-2[2], 813-3[2], respectively. For example, in a 90nm/65nm node, a range of 20nm to 200nm of separation between the second and third polysilicon gates 813-2[1], 813-3[1] may allow formation of a charge storage layer 814[1], e.g. the SAN layer, in the space between the second and third polysilicon gates 813-2[1], 813-3[1]. Contacts 816-1 and 816-2 may be formed in the active region 815 over the diffusion regions 811-1 and 811-4, respectively, for charging the diffusion regions 811-1, 811-4 with voltage signals applied to the contacts 816-1, 816-2.

The above description of FIG. 12 relates to a NAND-type array configuration. A NOR-type array may comprise a plurality of memory cells, each configured as the memory cell 300. Therefore, further description of the NOR-type array is omitted for simplicity.

To sum up, as shown in FIG. 4 to FIG. 11, a memory cell provided by the present invention can have the one-time programming function and the multi-time programming function. That is, different voltages can be applied to a bit line, a word line, and a program line coupled to the memory cell to realize the one-time programming function and the multi-time programming function easily. Thus, compared to the prior art, the memory cell not only has better performance than the prior art, but also has simpler structure to realize the one-time programming function and the multi-time programming function.

## Claims

1. A non-volatile semiconductor memory cell (300) with dual functions comprising:
a substrate of a first conductivity type comprising an active region (315);
a first gate (313-1) formed fully on the active region (315) for receiving a select-gate voltage; wherein :
a second gate (313-2) formed partially on the active region (315) on a first side of the first gate (313-1) for receiving a first voltage corresponding to a one-time programming function of the dual function and a second voltage corresponding to a multi-time programming function of the dual function, the first gate (313-1) and the second gate (313-2) are separated by a first distance;
a third gate (313-3) formed partially on the active region (315) on the first side of the first gate (313-1) for receiving the first voltage corresponding to the one-time programming function and the second voltage corresponding to the multi-time programming function, the first gate (313-1) and the third gate (313-3) are separated by the first distance and the second gate (313-2) and the third gate (313-3) are separated by a second distance;
a charge storage layer (314) formed on a surface of the active region (315), the charge storage layer (314) filled between the second gate (313-2) and the third gate (313-3);
a first diffusion region (311-1) of a second conductivity type opposite the first conductivity type formed on the surface of the active region (315) on a second side of the first gate (313-1) opposite the first side of the first gate (313-1) for receiving a third voltage corresponding to the one-time programming function and a fourth voltage corresponding to the multi-time programming function;
a second diffusion region (311-2) of the second conductivity type formed on the surface of the active region (315) on a first side of the second gate (313-2) opposite the first side of the first gate (313-1) for receiving a fifth voltage corresponding to the multi-time programming function;
a third diffusion region (311-3) of the second conductivity type formed on the surface of the active region (315) between the first gate (313-1) and the second and third gate (313-3); **characterized by**:
an oxide layer (320) below the second gate (313-2) and the third gate (313-3) ruptured with the first voltage wherein the select-gate voltage is half the first voltage, and the third voltage is equal to grounded voltage in program mode of the one-time programming function.

2. The non-volatile semiconductor memory cell (300) with dual functions of claim 1, further **characterized in that** the first distance and the second distance are measured along perpendicular axes.

3. The non-volatile semiconductor memory cell (300) with dual functions of claims 1, or 2, further **characterized in that** the first distance and the second distance are in a range suitable for the charge storage layer (314) to be self-aligning.

4. The non-volatile semiconductor memory cell (300) with dual functions of claim 3, further **characterized in that** the range is from 20 nanometers to 200 nanometers.

5. The non-volatile semiconductor memory cell (300) with dual functions of claims 1 or 3, further **characterized in that** the second distance is of a size that does not form an SAN (self-aligning nitride) layer between the first polysilicon gate (313-1) and the second and third polysilicon gates (313-2, 313-3).

6. A method of operating the non-volatile semiconductor memory cell (300) with dual functions of claim 1 **characterized by**:
applying the select-gate voltage to the first gate (313-1):
applying the first voltage to the second gate and third gates (313-2, 313-3) and applying the third voltage to the first diffusion region (311-1) when performing the one-time programming function; and
applying the second voltage to the second gate and third gates (313-2, 313-3), applying the fourth voltage to the first diffusion region (311-1), and applying the fifth voltage to the second diffusion region when performing the multi-time programming function.

7. The method of operating the non-volatile semiconductor memory cell (300) with dual functions of claim 6, further **characterized in that** the first voltage is larger than grounded voltage, and the third voltage is equal to grounded voltage in read mode of the one-time programming function.

8. The method of operating the non-volatile semiconductor memory cell (300) with dual functions of claim 6, further **characterized in that** the second voltage is higher than 0 Volts, the select-gate voltage is higher than 0 Volts, the fourth voltage is equal to 0 Volts, and the fifth voltage is higher than 0 Volts in program mode of the multi-time programming function.

9. The method of operating the non-volatile semiconductor memory cell (300) with dual functions of claim 6, further **characterized in that** the second voltage is lower than 0 Volts, the select-gate voltage is equal to 0 Volts, the fourth voltage is floating, and the fifth voltage is higher than 0 Volts in erase mode of the multi-time programming function.

## Patentansprüche

1. Nichtflüchtige Halbleiterspeicherzelle (300) mit Doppelfunktionen umfassend:
Ein Substrat eines ersten Leitfähigkeitstyps umfassend eine aktive Region (315);
ein erstes Gate (313-1), das vollständig auf der aktiven Region (315) gebildet ist, um eine Gate-Ansteuerspannung zu erhalten, worin
ein zweites Gate (313-2) teilweise auf der aktiven Region (315) an einer ersten Seite des ersten Gates (313-1) gebildet ist, um eine erste Spannung zu erhalten, die einer einmaligen Programmierfunktion der Doppelfunktion entspricht, sowie eine zweite Spannung, die einer mehrfachen Programmierfunktion der Doppelfunktion entspricht, wobei das erste Gate (313-1) und das zweite Gate (313-2) durch eine erste Distanz voneinander getrennt sind;
ein drittes Gate (313-3) teilweise auf der aktiven Region (315) an der ersten Seite des ersten Gates (313-1) gebildet ist, um eine erste Spannung zu erhalten, die der einmaligen Programmierfunktion entspricht, sowie eine zweite Spannung, die der mehrfachen Programmierfunktion entspricht, wobei das erste Gate (313-1) und das dritte Gate (313-3) durch die erste Distanz voneinander getrennt sind und das zweite Gate (313-2) und das dritte Gate (313-3) durch eine zweite Distanz voneinander getrennt sind;
eine Ladungsspeicherschicht (314) auf einer. Oberfläche der aktiven Region (315) gebildet ist, wobei die Ladungsspeicherschicht (314) zwischen dem zweiten Gate (313-2) und dem dritten Gate (313-3) aufgefüllt vorliegt;
ein erster Diffusionsbereich (311-1) eines zweiten Leitfähigkeitstyps umgekehrt zum ersten Leitfähigkeitstyp auf der Oberfläche der aktiven Region (315) an einer zweiten Seite des ersten Gates (313-1) gegenständig zur ersten Seite des ersten Gates (313-1) gebildet ist, um eine dritte Spannung zu erhalten, die der einmaligen Programmierfunktion entspricht, sowie eine vierte Spannung, die der mehrfachen Programmierfunktion entspricht;
ein zweiter Diffusionsbereich (311-2) des zweiten Leitfähigkeitstyps auf der Oberfläche der aktiven Region (315) an einer ersten Seite des zweiten Gates (313-2) gegenständig zur ersten Seite des ersten Gates (313-1) gebildet ist, um eine fünfte Spannung zu erhalten, die der mehrfachen Programmierfunktion entspricht;
ein dritter Diffusionsbereich (311-3) des zweiten Leitfähigkeitstyps auf der Oberfläche der aktiven Region (315) zwischen dem ersten Gate (313-1) und dem zweiten und dritten Gate gebildet ist,
**gekennzeichnet durch**
eine Oxidschicht (320) unterhalb des zweiten Gates (313-2) und des dritten Gates (313-3), die durch die erste Spannung zerbrochen wird, wobei die Gate-Ansteuerspannung halb so groß wie die erste Spannung ist, und wobei die dritte Spannung gleich der geerdeten Spannung im Programmiermodus der einmaligen Programmierfunktion ist.

2. Nichtflüchtige Halbleiterspeicherzelle (300) mit Doppelfunktionen nach Anspruch 1, ferner **dadurch gekennzeichnet, dass** die erste Distanz und die zweite Distanz entlang rechtwinkeligen Achsen gemessen werden.

3. Nichtflüchtige Halbleiterspeicherzelle (300) mit Doppelfunktionen nach Anspruch 1 oder 2, ferner **dadurch gekennzeichnet, dass** die erste Distanz und die zweite Distanz in einem Bereich liegen, der für eine Selbstausrichtung der Ladungsspeicherschicht (314) geeignet ist.

4. Nichtflüchtige Halbleiterspeicherzelle (300) mit Doppelfunktionen nach Anspruch 3, ferner **dadurch gekennzeichnet, dass** der Bereich zwischen 20 nm und 200 nm liegt.

5. Nichtflüchtige Halbleiterspeicherzelle (300) mit Doppelfunktionen nach Anspruch 1 oder 3, ferner **dadurch gekennzeichnet, dass** die zweite Distanz eine Größe aufweist, die keine SAN (selbstausrichtendes Nitrid) -Schicht zwischen dem ersten Polysiliziumgate (313-1) und dem zweiten und dritten Polysiliziumgate (313-2, 313-3) bildet.

6. Verfahren zum Betreiben der nichtflüchtigen Halbleiterspeicherzelle (300) mit Doppelfunktionen nach Anspruch 1, **gekennzeichnet durch**:
Anlegen der Gate-Ansteuerspannung an dem ersten Gate (313-1);
Anlegen der ersten Spannung an dem zweiten und dritten Gate (313-2, 313-3) und Anlagen der dritten Spannung an dem ersten Diffusionsbereich (311-1) beim Durchführen der einmaligen Programmierfunktion; und
Anlegen der zweiten Spannung an dem zweiten und dritten Gate (313-2, 313-3) und Anlagen der vierten Spannung an dem ersten Diffusionsbereich (311-1) und Anlagen der fünften Spannung an dem zweiten Diffusionsbereich beim Durchführen der mehrmaligen Programmierfunktion.

7. Verfahren zum Betreiben der nichtflüchtigen Halbleiterspeicherzelle (300) mit Doppelfunktionen nach Anspruch 6, ferner **dadurch gekennzeichnet, dass** die erste Spannung größer als die geerdete Spannung ist, und dass die dritte Spannung gleich der geerdeten Spannung im Lesemodus der einmaligen Programmierfunktion ist.

8. Verfahren zum Betreiben der nichtflüchtigen Halbleiterspeicherzelle (300) mit Doppelfunktionen nach Anspruch 6, ferner **dadurch gekennzeichnet, dass** im Programmiermodus der mehrfachen Programmierfunktion die zweite Spannung höher als 0 Volt ist, die Gate-Ansteuerspannung höher als 0 Volt ist, die vierte Spannung gleich 0 Volt ist und die fünfte Spannung höher als 0 Volt ist.

9. Verfahren zum Betreiben der nichtflüchtigen Halbleiterspeicherzelle (300) mit Doppelfunktionen nach Anspruch 6, ferner **dadurch gekennzeichnet, dass** im Löschmodus der mehrfachen Programmierfunktion die zweite Spannung niedriger als 0 Volt ist, die Gate-Ansteuerspannung gleich 0 Volt ist, die vierte Spannung fließt ist und die fünfte Spannung höher als 0 Volt ist.

## Revendications

1. Cellule de mémoire à semi-conducteurs non volatile (300) à double fonction comprenant :
un substrat d'un premier type de conductivité comprenant une région active (315) ;
une première grille (313-1) formée entièrement sur la région active (315) pour recevoir une tension de grille de sélection;
une seconde grille (313-2) étant formée partiellement sur la région active (315) sur un premier côté de la première grille (313-1) pour recevoir une première tension correspondant à une fonction de programmation unique de la double fonction et une seconde tension correspondant à une fonction de programmation multi-temps de la double fonction, la première grille (313-1) et la seconde grille (313-2) étant séparées par une première distance ;
une troisième grille (313-3) formée partiellement sur la région active (315) sur le premier côté de la région de la première grille (313-1) pour recevoir la première tension correspondant à la fonction de programmation unique et la seconde tension correspondant à la fonction de programmation multi-temps, la première grille (313-1) et la troisième grille (313-3) étant séparées par la première distance et la seconde grille (313-2) et la troisième grille (313-3) étant séparées par une seconde distance;
une couche de stockage de charge (314) formée sur une surface de la région active (315), la couche de stockage de charge (314) étant remplie entre la deuxième grille (313-2) et la troisième grille (313-3) ;
une première région de diffusion (311-1) d'un second type de conductivité opposé au premier type de conductivité étant formée sur la surface de la région active (315) sur un second côté de la première grille (313-1) opposé au premier côté de la première grille (313-1) pour recevoir une troisième tension correspondant à la fonction de programmation unique et une quatrième tension correspondant à la fonction de programmation multi-temps;
une seconde région de diffusion (311-2) du second type de conductivité étant formée sur la surface de la région active (315) sur un premier côté de la seconde grille (313-2) opposé au premier côté de la première grille (313-1) pour recevoir une cinquième tension correspondant à la fonction de programmation multi-temps ;
une troisième région de diffusion (311-3) du second type de conductivité étant formée sur la surface de la région active (315) entre la première grille (313-1) et la seconde grille et la troisième grille (313-3);
**caractérisé par**
une couche d'oxyde (320) au-dessous de la deuxième grille (313-2) et de la troisième grille (313-3) rompue avec la première tension, la tension de grille de sélection étant la moitié de la première tension, et la troisième tension étant égale à la tension mise à la terre en mode programme de la fonction de programmation unique.

2. Cellule de mémoire à semi-conducteurs non volatile (300) présentant les doubles fonctions selon la revendication 1, **caractérisée en outre en ce que** la première distance et la seconde distance sont mesurées le long d'axes perpendiculaires.

3. Cellule de mémoire à semi-conducteurs non volatile (300) présentant les doubles fonctions selon les revendications 1, ou 2, **caractérisée en outre en ce que** la première distance et la seconde distance sont dans une plage appropriée pour que la couche de stockage de charge (314) soit auto-alignée.

4. Cellule de mémoire à semi-conducteurs non volatile (300) présentant les doubles fonctions selon la revendication 3, **caractérisée en outre en ce que** la plage est comprise entre 20 nanomètres et 200 nanomètres.

5. Cellule de mémoire à semi-conducteurs non volatile (300) présentant les doubles fonctions selon les revendications 1 ou 3, **caractérisée en outre en ce que** la seconde distance est d'une taille qui ne forme pas une couche SAN (nitrure à auto-alignement) entre la première grille de polysilicium (313-1) et les deuxième et troisième grilles de polysilicium (313-2, 313-3).

6. Procédé de fonctionnement de la cellule de mémoire à semi-conducteurs non volatile (300) présentant les doubles fonctions selon la revendication 1, **caractérisé par** :
l'application de la tension de grille de sélection à la première grille (313-1) ;
l'application de la première tension à la deuxième grille et à la troisième grille (313-2, 313-3) et l'application de la troisième tension à la première région de diffusion (311-1) lors de la réalisation de la première fonction de programmation unique ; et
l'application de la seconde tension à la seconde grille et à la troisième grille (313-2, 313-3), l'application de la quatrième tension à la première région de diffusion (311-1), et l'application de la cinquième tension à la seconde région de diffusion lors de la réalisation de la fonction de programmation multi-temps.

7. Procédé de fonctionnement de la cellule de mémoire à semi-conducteurs non volatile (300) présentant les doubles fonctions selon la revendication 6 **caractérisé en outre en ce que** la première tension est supérieure à la tension mise à la terre, et la troisième tension est égale à la tension mise à la terre en mode lecture de la fonction de programmation unique.

8. Procédé de fonctionnement de la cellule de mémoire à semi-conducteurs non volatile (300) présentant les doubles fonctions de la revendication 6 **caractérisé en outre en ce que** la seconde tension est supérieure à 0 volt, la tension de grille de sélection est supérieure à 0 volt, la quatrième tension est égale à 0 volt, et la cinquième tension est supérieure à 0 volt dans un mode de programme de la fonction de programmation multi-temps.

9. Procédé de fonctionnement de la cellule de mémoire à semi-conducteurs non volatile (300) présentant les doubles fonctions selon la revendication 6 **caractérisé en outre en ce que** la seconde tension est inférieure à 0 volt, la tension de grille de sélection est égale à 0 volt, la quatrième tension est flottante, et la cinquième tension est supérieure à 0 volt dans un mode d'effacement de la fonction de programmation multi-temps.
